# FASCICULE DE BREVET EUROPEEN

(11) **EP 2 577 730 B1**
(45) Date de publication et mention de la délivrance du brevet: **09.04.2014**
(21) Numéro de dépôt: 11723087.0
(22) Date de dépôt: 06.06.2011
(51) Int. Cl.: H01L 21/74, H01L 21/822, H01L 27/06, H01L 29/78, H01L 29/786, H01L 27/115

(54) **CIRCUIT INTEGRE A DISPOSITIF DE TYPE FET SANS JONCTION ET A DEPLETION**
INTEGRIERTE SCHALTUNG MIT EINEM ÜBERGANGSLOSEN FET MIT VERARMUNGSSCHICHT
INTEGRATED CIRCUIT HAVING A JUNCTIONLESS DEPLETION-MODE FET DEVICE

(30) Priorité: 07.06.2010 FR 1054455
(43) Date de publication de la demande: 10.04.2013
(73) Titulaire: Commissariat à l'Énergie Atomique et aux Énergies Alternatives, 75015 Paris (FR)
(72) Inventeur: ERNST, Thomas, F-38210 Morette (FR); JAUD, Marie-Anne, FR-38640 CLAIX (FR); BATUDE, Perrine, F-38000 Grenoble (FR)
(74) Mandataire: Ilgart, Jean-Christophe
(86) Numéro de dépôt international: PCT/EP2011/059301
(87) Numéro de publication internationale: WO 2011/154360

(56) Documents cités:
- EP-A1- 0 419 136
- WO-A1-2006/138071
- US-A1- 2005 176 194
- POUPON G ET AL: "System on Wafer: A New Silicon Concept in SiP", PROCEEDINGS OF THE IEEE, IEEE. NEW YORK, US, vol. 97, no. 1, 1 janvier 2009 (2009-01-01), pages 60-69, XP011252832, ISSN: 0018-9219 cité dans la demande

## Description

### DOMAINE TECHNIQUE

L'invention concerne le domaine des circuits intégrés, et plus particulièrement celui des circuits intégrés tridimensionnels, comportant plusieurs niveaux électroniques superposés les uns au-dessus des autres, chaque niveau comportant un ou plusieurs dispositifs microélectroniques tels que des transistors à effet de champ (FET) et/ou des interconnexions électriques. L'invention concerne également un procédé de réalisation de circuit intégré.

L'invention concerne notamment la réalisation de circuits intégrés tridimensionnels très denses comprenant plusieurs niveaux électroniques, comprenant des dispositifs microélectroniques, interconnectés entre eux par des niveaux d'interconnexions électriques.

L'invention trouve de nombreuses applications dans les domaines de l'électronique faisant appel à des structures de type FET, tels que celui des logiques reconfigurables, des mémoires statiques (SRAM) tridimensionnelles, des mémoires de type flash tridimensionnelles, de l'adressage de mémoires, des capteurs NEMS (nanosystèmes électromécaniques), des capteurs chimiques ChemFET, etc.

### ÉTAT DE LA TECHNIQUE ANTÉRIEURE

Afin d'améliorer la compacité des circuits intégrés, on cherche à augmenter la densité d'intégration des composants électroniques et des interconnexions électriques faisant partie de ces circuits intégrés.

Une voie pour augmenter cette densité d'intégration est de réaliser des circuits intégrés tridimensionnels, c'est-à-dire comportant plusieurs niveaux électroniques superposés les uns au-dessus des autres, chaque niveau comportant un ou plusieurs dispositifs microélectroniques, tels que des transistors à effet de champ (FET), connectés à des niveaux d'interconnexions électriques.

Le document « 3-D Hyperintegration and Packaging Technologies for Micro-Nano Systems » de J.Q. LU, Proceedings of the TEEE, vol. 97, n°1, janvier 2009, décrit plusieurs types de circuits intégrés tridimensionnels. Pour réaliser de tels circuits intégrés, les différents niveaux du circuit intégré sont tout d'abord réalisés indépendamment les uns des autres sur différents substrats. Ces niveaux sont ensuite solidarisés les uns aux autres, puis interconnectés par des vias traversant et des interconnexions électriques réalisés entre les différents niveaux pour relier électriquement les éléments réalisés sur ces niveaux.

Un tel procédé de réalisation de circuits intégrés ne permet toutefois pas d'obtenir de très fortes densités d'intégration compte tenu des tolérances d'alignements entre les dispositifs électroniques des différents niveaux qui doivent être prises en compte lors de la solidarisation des différents niveaux.

Une variante de réalisation de tels circuits intégrés tridimensionnels consiste à réaliser tout d'abord les éléments électroniques d'un premier niveau sur un premier substrat, puis à réaliser les éléments électroniques d'un second niveau sur un second substrat en ayant solidarisé au préalable le second substrat au premier substrat.

Cette variante permet de s'affranchir des tolérances d'alignements entre les dispositifs électroniques des différents niveaux car les dispositifs du second niveau ne sont réalisés qu'après avoir solidarisé le second substrat au premier substrat. Ainsi, seule la tolérance due aux imprécisions des étapes lithographiques mises en oeuvre pour réaliser les dispositifs du second niveau est à prendre en compte, ce qui permet d'obtenir une plus grande densité d'intégration des composants électroniques et des interconnexions électriques dans un circuit intégré ainsi réalisé.

Un tel procédé de réalisation de circuits intégrés pose toutefois des problèmes lorsque l'on souhaite réaliser des dispositifs nécessitant la mise en oeuvre d'étapes impliquant des budgets thermiques importants, comme par exemple des transistors MOSFET, au-dessus de niveaux comportant des interconnexions électriques et/ou d'autres transistors MOSFET. En effet, lors de la réalisation des transistors MOSFET, il est nécessaire de mettre en oeuvre une étape d'activation thermique des dopants implantés dans la couche active, au niveau des régions de source et de drain des transistors. Une telle étape d'activation thermique doit généralement être réalisée, dans le cas du silicium, à une température supérieure à environ 850°C. Or, la présence d'interconnexions électriques sous la couche active comportant les dopants à activer est incompatible avec la mise en oeuvre d'une telle activation thermique compte tenu des températures trop élevées devant être atteintes. Cette incompatibilité se retrouve également lorsque le niveau inférieur comporte des transistors MOSFET qui sont alors détériorés si une telle activation thermique est réalisée pour activer les dopants d'une couche active superposée au-dessus de ces transistors.

Le document « System on Wafer : A New Silicon Concept in SiP » de G. Poupon et al., Proceedings of the IEEE, vol. 97, n°1, Janvier 2009, décrit un circuit intégré tridimensionnel dans lequel un premier niveau comporte des transistors FET de type nMOS réalisés dans une couche active de silicium et un second niveau, disposé au-dessus du premier niveau, comporte des transistors FET de type pMOS réalisés dans une couche active de germanium. Etant donné que les transistors du second niveau sont de type pMOS et sont réalisés dans une couche active de germanium, la température d'activation des dopants de ces transistors est inférieure à environ 600°C, et donc ne dégrade pas ou peu les transistors nMOS réalisés dans la couche active inférieure de silicium. On obtient donc un circuit intégré tridimensionnel à co-intégration SoI (silicium sur isolant) / GeOI (germanium sur isolant).

Un tel circuit intégré a toutefois pour inconvénient d'être limité à une superposition de transistors de type pMOS au-dessus de transistors de type nMOS, la couche active supérieure devant nécessairement être à base de germanium. De plus, la température d'activation est supérieure à la température maximum tolérée par des interconnexions à base de cuivre qui sont utilisées pour les noeuds technologiques avancés, qui ne supportent pas des températures supérieures à environ 450°C. Un tel circuit ne permet donc pas de réaliser un ou plusieurs niveaux de transistors au-dessus de telles interconnexions. D'autres matériaux moins sensibles aux budgets thermiques, par exemple du tungstène, peuvent être envisagés pour réaliser les interconnexions, mais la résistivité plus importante de ces matériaux dégraderait alors les performances dynamiques du circuit.

### EXPOSÉ DE L'INVENTION

Un but de la présente invention est de proposer un nouveau type de circuit intégré à dispositif de type FET ne présentant pas les inconvénients des circuits intégrés de l'art antérieur, c'est-à-dire permettant d'être réalisé avec une très forte densité d'intégration sans être limité à une nature particulière des matériaux et/ou des dopants utilisés dans le circuit intégré, ni dans le nombre de niveaux superposés que peut comporter le circuit intégré, et ni dans l'utilisation d'interconnexions particulières devant supporter un budget thermique élevé.

Pour cela, il est proposé un circuit intégré comportant au moins :
- un substrat sur lequel est réalisé au moins un circuit électronique de type MOS et/ou au moins un niveau d'interconnexions électriques,
- un dispositif de type FET sans jonction et à déplétion comprenant au moins une portion uniformément dopée de semi-conducteur cristallin solidarisée au substrat.

L'invention concerne un procédé de réalisation d'un tel circuit intégré. Ce circuit intégré fait appel à un dispositif de type FET sans jonction et à déplétion. Par rapport à un dispositif MOSFET classique, le dispositif FET sans jonction et à déplétion ne comporte pas de jonction, par exemple de type p-n ou n-n+ ou p-p+, formée entre la source et le canal, et entre le drain et le canal. La source, le drain et le canal sont formés dans la portion uniformément dopée de semi-conducteur. Le fait que la portion de semi-conducteur soit uniformément dopée signifie qu'il n'y a pas de variation de la concentration de dopants dans la portion de semi-conducteur. Ainsi, le passage ou non d'un courant entre la source et le drain est commandé uniquement par la création ou non d'une zone de déplétion dans la région de canal.

En faisant appel à un dispositif de type FET sans jonction et à déplétion, la structure du circuit intégré peut donc d'avoir un ou plusieurs dispositifs de type FET cristallins, par exemple des transistors, réalisés au-dessus et/ou entre des niveaux d'interconnexions électriques et/ou d'autres circuits électroniques de type MOS.

Le circuit intégré peut comporter en outre au moins une couche à base d'un matériau diélectrique recouvrant le substrat et le circuit électronique de type MOS et/ou le niveau d'interconnexions électriques, et disposée entre le substrat et le dispositif de type FET sans jonction et à déplétion. La couche à base du matériau diélectrique peut également être un empilement de plusieurs couches à base d'un ou plusieurs matériaux diélectriques.

Le circuit intégré peut comporter en outre une pluralité de niveaux d'interconnexions électriques disposés dans la couche (ou l'empilement de couches) à base du matériau diélectrique, le circuit électronique de type MOS pouvant comporter plusieurs transistors MOS reliés électriquement aux niveaux d'interconnexions électriques par des vias formés dans la couche à base du matériau diélectrique.

Le circuit intégré peut comporter en outre au moins une seconde couche (ou un second empilement de couches) à base d'un matériau diélectrique recouvrant au moins le dispositif de type FET sans jonction et à déplétion, et au moins un niveau d'interconnexions électriques disposé dans la seconde couche à base du matériau diélectrique relié électriquement au dispositif de type FET sans jonction et à déplétion par des vias formés dans la seconde couche à base du matériau diélectrique.

La portion uniformément dopée de semi-conducteur cristallin peut former un ou plusieurs nanofils de semi-conducteur cristallin uniformément dopé.

Le dispositif de type FET sans jonction et à déplétion peut être un transistor comportant un canal, une source et un drain formés par la portion uniformément dopée de semi-conducteur cristallin.

Le dispositif de type FET sans jonction et à déplétion peut comporter au moins une grille avant et/ou une grille arrière disposées en regard du canal du dispositif de type FET sans jonction et à déplétion.

Le dispositif de type FET sans jonction et à déplétion peut comporter, entre la grille avant et le canal et/ou entre la grille arrière et le canal, au moins une portion de matériau apte à stocker des charges électriques et disposée entre au moins deux portions de matériau diélectrique. Un tel dispositif FET forme alors un dispositif mémoire non volatile, le « diélectrique de grille », c'est-à-dire la structure se trouvant entre le canal et la grille, pouvant alors être composé d'un empilement de type oxyde / couche de stockage / oxyde, ou de tout autre type d'empilement permettant de stocker des charges électriques (SiO₂/SiN/SiO₂, SiO₂/Si/SiO₂, etc.). Dans le cas d'une couche intermédiaire, ou couche de stockage de charges, à base de silicium ou de tout autre matériau conducteur approprié, une telle couche forme alors une grille flottante dans laquelle une information peut être stockée.

Le dispositif de type FET sans jonction et à déplétion peut être un transistor de mémoire de type flash.

Le dispositif de type FET sans jonction et à déplétion peut être un capteur chimique de type ChemFET sans jonction et à déplétion.

Le circuit intégré peut comporter en outre au moins une couche de collage et/ou une couche barrière et/ou une couche d'arrêt disposée entre le substrat et le dispositif de type FET sans jonction et à déplétion.

L'invention concerne notamment un procédé de réalisation d'un circuit intégré, comportant au moins, dans cet ordre, les étapes de :
a) réalisation d'au moins un circuit électronique de type MOS et/ou d'au moins un niveau d'interconnexions électriques sur un substrat,
b) implantation uniforme de dopants dans au moins une partie d'une couche de semi-conducteur cristallin,
c) activation thermique des dopants implantés dans la partie de la couche de semi-conducteur cristallin,
d) solidarisation de la couche de semi-conducteur cristallin au substrat,
e) réalisation d'au moins un dispositif de type FET sans jonction et à déplétion comprenant une portion de la partie de la couche de semi-conducteur cristallin.

Etant donné que l'activation thermique des dopants implantés dans la couche de semi-conducteur cristallin est réalisée alors que la couche n'est pas encore solidarisée au substrat, cette étape d'activation thermique ne dégrade pas le circuit électronique MOS et/ou le ou les niveaux d'interconnexions électriques se trouvant sur le substrat.

De plus, étant donné que le dispositif de type FET sans jonction et à déplétion est réalisé après avoir solidarisé la couche de semi-conducteur cristallin, on s'affranchit des tolérances d'alignement entre le dispositif de type FET sans jonction et à déplétion et d'autres éléments du circuit intégré. Seule la tolérance due aux imprécisions des étapes lithographiques mises en oeuvre pour réaliser le dispositif de type FET sans jonction et à déplétion est à prendre en compte.

Le procédé peut comporter en outre, entre les étapes a) et d), par exemple entre les étapes a) et b), une étape de réalisation d'au moins une couche composée, ou à base, d'un matériau diélectrique recouvrant le substrat et le circuit électronique de type MOS et/ou le niveau d'interconnexions électriques, la couche de semi-conducteur cristallin étant solidarisée au substrat, à l'étape d), par l'intermédiaire de la couche composée du matériau diélectrique.

Le procédé peut comporter en outre, lors de la réalisation de la couche composée du matériau diélectrique, la réalisation d'une pluralité de niveaux d'interconnexions électriques disposés dans la couche composée du matériau diélectrique, le circuit électronique de type MOS comportant plusieurs transistors MOS reliés électriquement aux niveaux d'interconnexions électriques par des vias formés dans la couche composée du matériau diélectrique.

La couche de semi-conducteur cristallin peut être une couche superficielle d'un substrat SOI, et le procédé peut comporter en outre, entre les étapes d) et e), une étape de séparation de la couche de semi-conducteur et d'autres éléments du substrat SOI.

L'étape e) de réalisation du dispositif de type FET sans jonction et à déplétion peut être mise en oeuvre à une température inférieure à environ 450°C.

L'étape e) de réalisation du dispositif de type FET sans jonction et à déplétion peut comporter la réalisation d'une région d'isolation électrique dans la couche de semi-conducteur cristallin, autour de la portion de la partie de la couche de semi-conducteur cristallin.

L'étape e) de réalisation du dispositif de type FET sans jonction et à déplétion peut comporter une gravure de la couche de semi-conducteur cristallin autour de la portion de la partie de la couche de semi-conducteur cristallin, ladite portion formant un ou plusieurs nanofils de semi-conducteur cristallin uniformément dopé.

Le procédé peut comporter en outre, après l'étape e) de réalisation du dispositif de type FET sans jonction et à déplétion, la réalisation d'au moins une seconde couche composée, ou à base, d'un matériau diélectrique recouvrant au moins le dispositif de type FET sans jonction et à déplétion, et au moins un niveau d'interconnexions électriques disposé dans la seconde couche composée du matériau diélectrique relié électriquement au dispositif de type FET sans jonction et à déplétion par des vias formés dans la seconde couche composée du matériau diélectrique.

Le procédé peut comporter en outre, après l'étape c), un dépôt d'au moins un diélectrique de grille ou la réalisation d'un empilement comportant au moins une portion de matériau apte à stocker des charges électriques disposée entre au moins deux portions de matériau diélectrique, sur la couche de semi-conducteur cristallin, et la réalisation d'au moins une grille avant et/ou une grille arrière en regard du canal du dispositif de type FET sans jonction et à déplétion, le diélectrique de grille ou ledit empilement pouvant être disposé entre la grille avant et le canal et/ou entre la grille arrière et le canal. Le diélectrique de grille peut notamment être à base de SiO₂ et par exemple réalisé à une température supérieure à environ 700°C. Un tel diélectrique de grille peut également être formé par un empilement de plusieurs portions de matériaux diélectriques, par exemple un empilement de type ONO (oxyde / nitrure / oxyde).

Le procédé peut comporter en outre, entre les étapes b) et c) ou entre les étapes c) et d), un dépôt, sur la couche de semi-conducteur cristallin, d'au moins une couche de collage et/ou une couche barrière et/ou une couche d'arrêt. Cette ou ces couches intermédiaires, par exemple à base de matériaux diélectriques, peuvent par exemple permettre d'éviter une exo-diffusion de dopants lors de l'étape c), et/ou former une couche d'interface lors de l'étape d) de solidarisation qui peut être un collage moléculaire, et/ou former une couche d'arrêt pour des étapes ultérieures de nettoyage ou de gravure.

Le procédé peut comporter en outre, avant la mise en oeuvre de l'étape d), la solidarisation de la couche de semi-conducteur cristallin à une poignée temporaire, et comporter en outre, entre les étapes d) et e), la suppression de la poignée temporaire. Ainsi, il est possible de manipuler aisément la couche de semi-conducteur cristallin grâce à la poignée temporaire.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1, 3, et 5 à 7 représentent des circuits intégrés à dispositifs FET sans jonction et à déplétion réalisés selon un procédé objet de la présente invention, respectivement selon plusieurs modes de réalisation,
- les figures 2, 4 et 8 représentent des exemples de dispositifs FET sans jonction et à déplétion de circuits intégrés réalisés selon un procédé objet de la présente invention,
- les figures 9A à 9E représentent les étapes d'un procédé de réalisation d'un circuit intégré à dispositifs FET sans jonction et à déplétion, objet de la présente invention, selon un mode de réalisation particulier,
- les figures 10 et 11 représentent des courbes de mesure servant pour optimiser un dispositif de type FET sans jonction et à déplétion d'un circuit intégré réalisé selon un procédé objet de la présente invention,
- les figures 12A à 12E représentent les étapes d'un procédé de réalisation d'un circuit intégré à dispositifs FET sans jonction et à déplétion, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

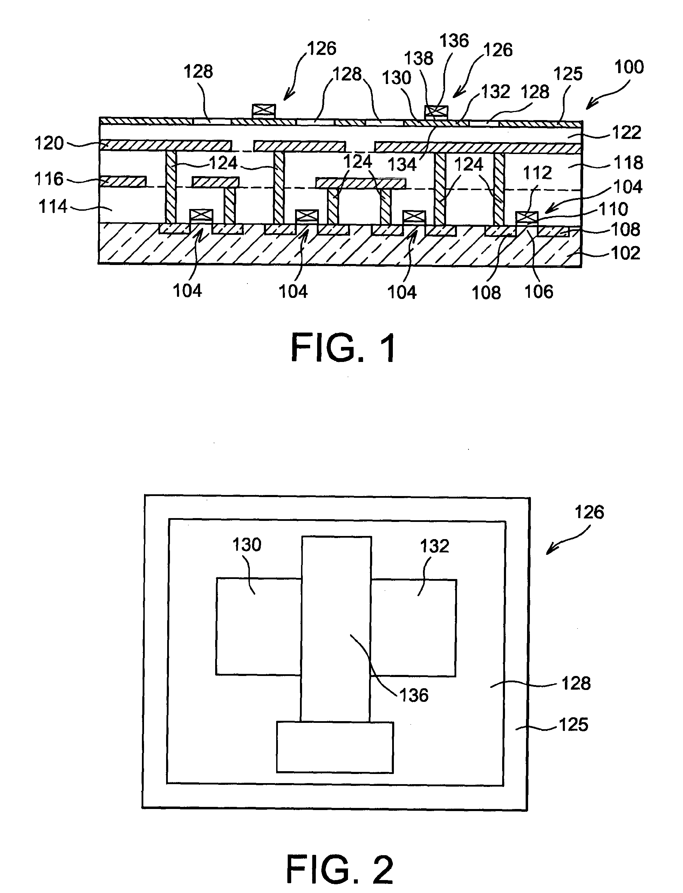

On se réfère tout d'abord à la figure 1 qui représente un circuit intégré 100 à dispositifs FET sans jonction et à déplétion 126 selon un premier mode de réalisation.

Le circuit intégré 100 comporte un substrat 102, par exemple à base de semi-conducteur tel que du silicium et de type bulk ou SOI (silicium sur isolant) ou FD-SOI (silicium sur isolant entièrement déserté) ou encore PD-SOI (silicium sur isolant partiellement déserté), dans lequel des transistors MOSFET 104 sont réalisés. Ces transistors MOSFET 104, par exemple de type nMOS, comportent chacun une zone de canal 106 de type P et des régions 108 de source et de drain de type N+ formées dans le substrat 102. Le canal 106 est surmonté d'un diélectrique de grille 110 et d'une grille 112.

Le substrat 102 et les transistors 104 sont recouverts par une première couche diélectrique 114, par exemple à base de SiO₂, sur laquelle un premier niveau d'interconnexions électriques 116 est formé. Une deuxième couche diélectrique 118 recouvre la première couche diélectrique 114 et le premier niveau d'interconnexions électriques 116. Un deuxième niveau d'interconnexions électriques 120 est formé sur la deuxième couche diélectrique 118. Enfin, une troisième couche diélectrique 122 recouvre la deuxième couche diélectrique 118 et le deuxième niveau d'interconnexions électriques 120. Les niveaux d'interconnexions électriques 116, 120 sont par exemple formés par des portions de matériau électriquement conducteur, par exemple du métal. Des vias 124, également à base d'un matériau électriquement conducteur tel que du métal, sont réalisés à travers les couche diélectriques 114 et 118 afin de relier électriquement les niveaux d'interconnexions électriques 116, 120 entre eux et/ou aux transistors 104, afin de contacter les régions de source et de drain 108 et les grilles 112 de ces transistors 104.

De manière générale, le circuit intégré 100 peut comporter un nombre plus ou moins important de niveaux d'interconnexions électriques disposés entre les couches diélectriques 114, 118, 122. De plus, les couches diélectriques 114, 118 et 122, lorsqu'elles sont à base d'un même matériau, peuvent être considérées comme une seule couche diélectrique dans laquelle les niveaux d'interconnexions électriques 116 et 120 sont disposés. Toutefois, les couches diélectriques 114, 118 et 122 peuvent également être à base de matériaux diélectriques différents.

La troisième couche diélectrique 122 est recouverte d'une couche mince de semi-conducteur cristallin 125, par exemple à base de silicium et d'épaisseur inférieure à environ 100 nm, par exemple dopée uniformément (même concentration de dopants le long de la couche 125) et d'un même type de dopage (N ou P). Des transistors de type FET sans jonction et à déplétion 126 sont réalisés dans la couche mince de semi-conducteur cristallin 125. Ces transistors 126 sont isolés électriquement les uns des autres par des portions diélectriques 128, par exemple à base de SiO₂, formées dans toute l'épaisseur de la couche mince cristalline 125, autour des transistors 126. Il est également possible que les transistors 126 soient isolés les uns des autres par une isolation de type « mesa », les portions diélectriques 128 étant remplacées dans ce cas par des zones de vide. Dans une autre variante, il est également possible que les portions diélectriques 128 fassent partie d'une couche de matériau diélectrique recouvrant les transistors 126.

Un exemple d'un tel transistor FET sans jonction et à déplétion 126 est représenté vu de dessus sur la figure 2. Ce transistor 126 comporte une portion de la couche mince de semi-conducteur 125 par exemple dopée uniformément selon un même type de dopage, par exemple dopée N. Cette portion de silicium dopée forme une source 130, un drain 132 et un canal 134 (référence visible sur la figure 1) du transistor FET sans jonction et à déplétion 126. Le canal 134 est disposé sous une grille 136 dopée selon un second type de dopage avantageusement opposé au dopage de la portion de la couche mince 125, par exemple du type P, et un diélectrique de grille 138. La grille 136 peut être à base d'un matériau métallique.

Dans une variante de réalisation, le transistor 126 peut comporter une grille flottante. Dans ce cas, le diélectrique de grille 138 est remplacé par un empilement de portions de matériaux permettant de réaliser un stockage de charges électriques, c'est-à-dire un stockage d'informations, dans une portion de stockage de cet empilement. Par exemple, lorsque le circuit intégré 100 est une mémoire de type flash, chacun des transistors 126 peut comporter, entre la zone active formant le canal du transistor et la grille du transistor, un empilement formé d'une portion de stockage, par exemple à base de Si ou de SiN, disposée entre deux portions de matériau diélectrique, par exemple à base de SiO₂.

Par rapport à un transistor MOSFET classique, le transistor FET sans jonction et à déplétion 126 ne comporte pas de jonction p-n entre la source 130 et le canal 134, et entre le drain 132 et le canal 134. Dans un tel transistor, la source 130, le drain 132 et le canal 134 sont formés par une portion de semi-conducteur dopée uniformément d'un même type de conductivité. Lorsqu'une tension nulle est appliquée sur la grille 136, la portion de la couche de semi-conducteur 125 formant la source 130, le drain 132 et le canal 134 est complètement désertée, empêchant la conduction du courant entre la source 130 et le drain 132. En appliquant une tension appropriée sur la grille, par exemple une tension positive lorsque le canal 134 est de type N, une zone non désertée, qui se comporte comme une résistance, se créée, pouvant conduire un courant entre la source 130 et le drain 132.

Il convient de noter que plus la couche de silicium 125 est mince, plus la désertion totale est aisément obtenue dans le canal 134. Ainsi, on choisira de préférence une couche mince 125 d'épaisseur comprise entre environ 3 nm et 100 nm selon le niveau de dopage dans la couche 125. Plus le niveau de dopage est faible, plus la désertion totale du canal est aisément obtenue. Toutefois, plus ce niveau de dopage est faible, plus les résistances des source et drain sont élevées.

L'optimisation du dopage et de l'épaisseur du canal peut donc être réalisée expérimentalement : pour une longueur de grille donnée, on choisit une épaisseur de canal permettant de réaliser aisément l'ensemble des étapes technologiques permettant de réaliser le circuit intégré 100, y compris les contacts électriques des source et drain. Cette épaisseur peut être par exemple comprise entre environ 3 nm et 100 nm, et par exemple égale à environ 10 nm. Le dopage réalisé dans la couche 125 peut correspondre alors au dopage maximum réalisable qui n'entraîne pas une amorphisation totale de la couche 125 avant recristallisation lors d'une activation thermique ultérieure. En effet, une amorphisation totale de la couche 125 retirerait la propriété monocristalline de cette couche 125. L'optimisation est alors réussie si le courant peut être correctement bloqué et si l'intensité du courant à l'état passant est suffisante en fonction de l'application réalisée. Si l'on souhaite augmenter le niveau de courant ON du dispositif, il est possible d'augmenter le dopage de la couche 125 jusqu'à ce que le niveau de fuite devienne alors intolérable. De plus, si l'on souhaite réduire le niveau de fuite du dispositif, on peut réduire alors son dopage et/ou l'épaisseur de la couche 125 jusqu'à ce que le niveau du courant ON soit trop faible pour l'application visée.

Compte tenu du fait que les transistors FET 126 sont des transistors sans jonction, il est donc possible de les réaliser après avoir solidarisé la couche mince 125 à la troisième couche diélectrique 122, en ayant pris soin d'implanter les dopants dans la couche mince de silicium 125 et d'activer thermiquement ces dopants préalablement à la solidarisation de la couche mince de silicium 125 avec la troisième couche diélectrique 122, évitant ainsi de soumettre les niveaux inférieurs d'interconnexions électriques 116 et 120 et les transistors MOS 104 aux budgets thermiques atteints lors de l'activation thermique des dopants implantés dans la couche mince de silicium 125.

Il est possible de réaliser le circuit intégré 100 tel que représenté sur la figure 1. Toutefois, il est également possible de réaliser au-dessus des transistors FET sans jonction et à déplétion 126 d'autres niveaux d'interconnexions électriques et/ou d'autres niveaux de dispositifs de type FET sans jonction et à déplétion. Il est également possible de recouvrir les transistors FET sans jonction et à déplétion par une couche diélectrique afin de solidariser le circuit intégré 100 à un autre circuit intégré.

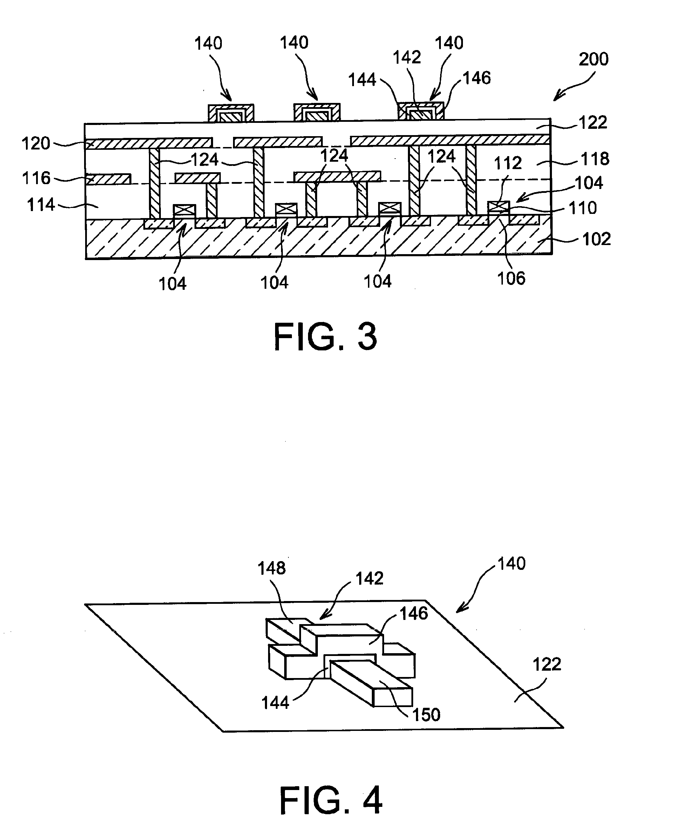

On se réfère à la figure 3 qui représente un circuit intégré 200 à dispositifs FET sans jonction et à déplétion 140 selon un deuxième mode de réalisation. Par rapport au circuit intégré 100, le circuit intégré 200 comporte des transistors FET sans jonction et à déplétion 140 ne comportant pas de portions de la couche mince de silicium 125 isolées électriquement du reste de la couche 125 par des portions de matériau diélectrique, mais comportent des nanofils 142 de silicium uniformément dopé obtenus par gravure dans la couche mince de silicium 125. Un exemple d'un tel transistor FET sans jonction et à déplétion 140 est représenté sur la figure 4. Sur cette 4, un seul nanofil 142 est représenté. Toutefois, le transistor FET sans jonction et à déplétion 140 peut comporter un ou plusieurs nanofils 142. Le nanofil 142 est recouvert partiellement par un diélectrique de grille 144 et par une grille 146, la portion du nanofil 142 se trouvant sous le diélectrique de grille 144 formant le canal du transistor FET 140. Le nanofil 142 forme également une source 148 et un drain 150 du transistor FET sans jonction et à déplétion 140. Le nanofil 142 a par exemple une épaisseur égale à environ 10 nm et peut comporter un niveau de dopage égal à environ 10¹⁹cm⁻³.

De manière analogue au transistor FET 126 précédemment décrit en liaison avec les figures 1 et 2, le transistor FET sans jonction et à déplétion 140 ne comporte pas de jonction p-n entre le canal et la source et entre le canal et le drain. Le fonctionnement du transistor FET sans jonction et à déplétion 140 est similaire à celui du transistor FET 126.

Dans une variante de réalisation, chacun des transistors FET sans jonction et à déplétion 140 peut comporter plusieurs nanofils semi-conducteur, chaque nanofil formant un canal, une source et un drain et étant recouvert au niveau du canal par une grille commune à tous les nanofils du transistor FET sans jonction et à déplétion 140. Les drains des nanofils sont reliés électriquement entre eux, de même que les sources des nanofils qui sont reliées électriquement entre elles.

De plus, comme pour le circuit intégré 100, il est possible de réaliser au-dessus des transistors FET sans jonction et à déplétion 140 d'autres niveaux d'interconnexions électriques et/ou d'autres niveaux électroniques comportant des dispositifs de type FET sans jonction et à déplétion.

L'optimisation du dopage et de l'épaisseur du canal peut là encore être réalisée expérimentalement, de manière analogue au circuit intégré 100.

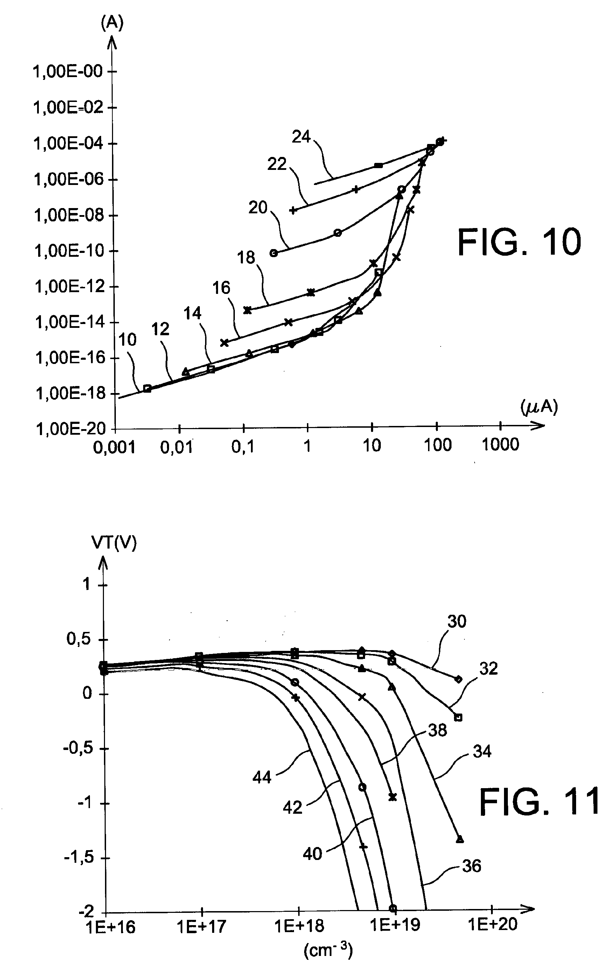

Les courbes représentées sur la figure 10 correspondent au courant (en A) à l'état OFF normalisé à Vg = Vt - (1/3) *V_{DD} en fonction du courant (en µA) à l'état ON normalisé à Vg = Vt + 2/3*V_{DD}, avec Vg tension appliquée sur la grille du transistor FET 140, Vt tension de seuil du transistor FET 140 et V_{DD} tension d'alimentation du transistor FET 140, pour différents diamètres de nanofil semi-conducteur 142. Les valeurs du courant à l'état ON augmentent en fonction d'un dopage croissant, ici compris entre environ 10¹⁶cm⁻³ et 5.10¹⁹ cm⁻³. Les courbes 10, 12, 14, 16, 18, 20, 22 et 24 correspondent respectivement à un diamètre de nanofil égale à 3 nm, 5 nm, 10 nm, 20 nm, 30 nm, 50 nm, 70 nm et 100 nm. Ces courbes illustrent le compromis réalisé entre dopage et épaisseur de la couche mince à partir de laquelle le ou les nanofils 142 sont issus, et les valeurs des courants à l'état ON et OFF obtenus. Ce schéma représente des tendances qualitatives pour une valeur de longueur de grille donnée, égale à environ 30 nm. Les courbes sont ici obtenues pour une structure comprenant des nanofils à grille totalement enrobante qui constitue un cas idéal pour le contrôle électrostatique. Pour une grille partiellement enrobante ou planaire, les tendances qualitatives seraient sensiblement similaires mais pour des épaisseurs ou diamètres inférieurs.

A partir des courbes représentées sur la figure 10, on voit donc que plus le diamètre est petit, plus le niveau de fuite est bas, en raison d'un meilleur contrôle électrostatique obtenu, mais plus le niveau de courant à l'état ON du transistor est bas.

En outre, plus le dopage est élevé, plus la résistivité du canal et les résistances séries sont faibles et plus le courant est élevé. Ainsi, à partir d'un certain niveau de dopage, le niveau de fuite peut augmenter brutalement car le transistor n'est pas complètement déserté. Il faut donc éviter le couple dopage/épaisseur correspondant.

Les courbes représentées sur la figure 11 représentent la tension de seuil d'un transistor de type NMOS sans jonction et à déplétion comprenant un matériau de grille de type « mid-gap », par exemple à base de TiN, en fonction du niveau de dopage réalisé dans la couche active du transistor. Les courbes 30, 32, 34, 36, 38, 40, 42 et 44 correspondent respectivement à une couche active d'épaisseur égale à environ 3 nm, 5 nm, 10 nm, 20 nm, 30 nm, 50 nm, 70 nm et 100 nm.

Cette tension de seuil est de préférence comprise en environ un quart et la moitié de la tension d'alimentation, par exemple égale à environ 0,4 V pour une alimentation à 1 volt dans le cas d'une application logique.

A partir des courbes de la figure 11, on voit que pour des dopages trop élevés, la tension de seuil chute brutalement. Cela s'explique par la difficulté à bloquer le transistor à fort dopage car l'ensemble de la couche active peut ne pas être désertée. Pour une application mémoire flash, sa plage de variation peut-être bien plus large et peut être de plusieurs volts, et dépend également des charges stockées dans la couche de stockage.

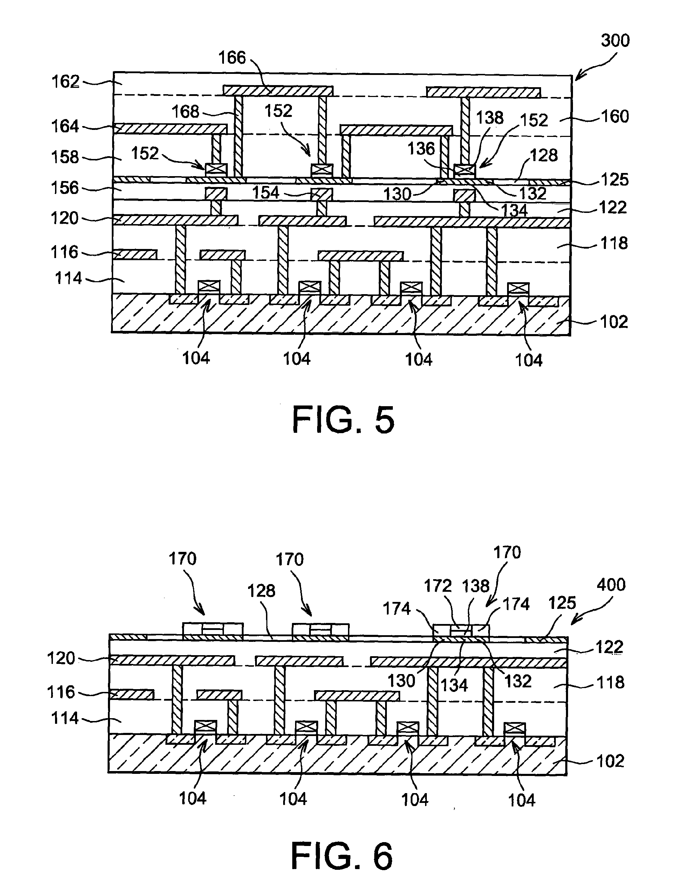

On se réfère maintenant à la figure 5 qui représente un circuit intégré 300 à dispositifs FET sans jonction et à déplétion 152 selon un troisième mode de réalisation.

Par rapport au circuit intégré 100 précédemment décrit en liaison avec la figure 1, le circuit intégré 300 comporte des transistors FET sans jonction et à déplétion 152 différents des transistors 126 précédemment décrits. En effet, par rapport aux transistors FET 126, chacun des transistors FET 152 comporte en outre une grille arrière disposée face au canal 134 du transistor 152. Ces grilles arrière 154 sont réalisées par des portions de matériau électriquement conducteur, par exemple de métal, disposées sur la troisième couche diélectrique 122 et recouvertes par une autre couche diélectrique 156 disposée entre la troisième couche diélectrique 122 et la couche mince de silicium 125. De fines portions de la couche diélectrique 156 sont intercalées entre les grilles arrière 154 et les zones de canal 134, formant des diélectriques de grilles arrière. Le fonctionnement des transistors FET sans jonction et à déplétion 152 est analogue à celui des transistors FET 126, excepté que la zone de déplétion peut être formée, dans le canal, par une tension appropriée appliquée sur la grille avant 136 du transistor FET 152 et/ou sur la grille arrière 154 du transistor FET 152.

De plus, sur l'exemple de la figure 5, les transistors FET sans jonction et à déplétion 152 sont recouverts par plusieurs couches diélectriques 158, 160 et 162 dans lesquelles sont réalisés des niveaux d'interconnexions électriques 164, 166 et des vias conducteurs 168 reliant par exemple ces niveaux d'interconnexions électriques 164, 166 à des zones de contact (grille, source ou drain) des transistors FET 152.

Un circuit intégré 400 à dispositifs FET sans jonction et à déplétion 170 selon un quatrième mode de réalisation est représenté sur la figure 6.

Dans ce quatrième mode de réalisation, les dispositifs FET sans jonction et à déplétion 170 sont des capteurs chimiques de type ChemFET. Par rapport à un transistor FET sans jonction et à déplétion, un tel capteur ChemFET 170 comporte, à la place de la portion de matériau électriquement conducteur formant la grille du transistor FET, une portion 172 de matériau sensible chimiquement à certaines charges destinées à être détectées par le capteur ChemFET 170 et disposée entre des portions diélectriques 174 recouvrant la source et le drain 132 du capteur ChemFET 170. Dans un tel capteur, le piégeage d'ions ou l'apparition de charges au niveau du diélectrique de grille 138 induit une modification de la tension de seuil du capteur ChemFET 170 et entraîne une variation du courant destiné à circuler dans le canal 134 entre le drain 132 et la source 130 du capteur 170.

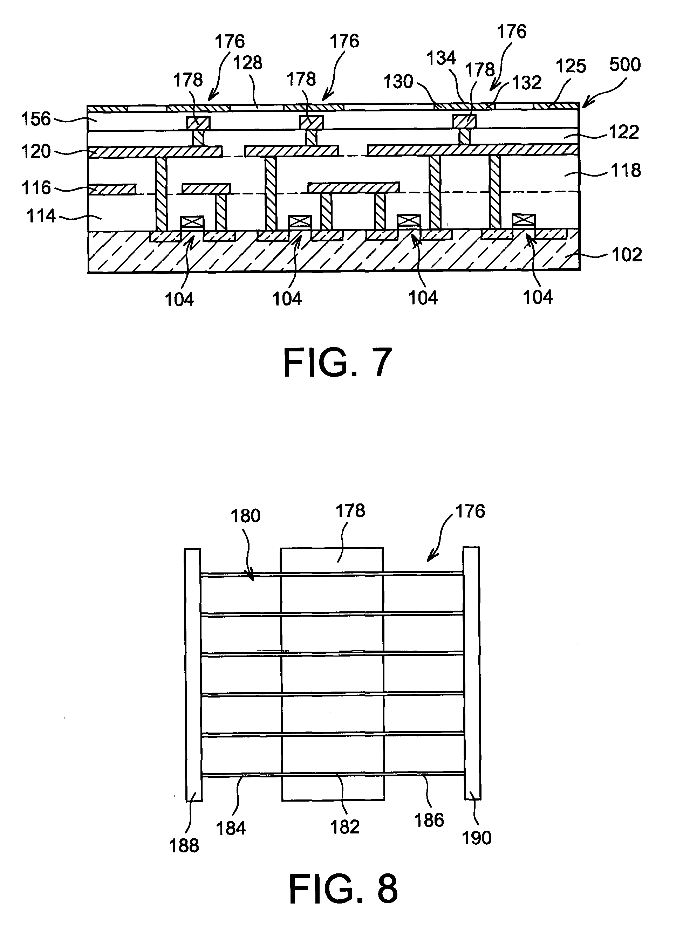

On se réfère à la figure 7 qui représente un circuit intégré 500 à dispositifs FET sans jonction et à déplétion 176 selon un cinquième mode de réalisation.

Par rapport au circuit intégré 100 précédemment décrit en liaison avec la figure 1, le circuit intégré 500 comporte des transistors FET sans jonction et à déplétion 176 comportant des sources 130, des drains 132 et des canaux 134 formés dans la couche mince de semi-conducteur cristallin 125, mais ne comportant pas de grilles avant. La formation ou non des zones de déplétion dans les canaux 134 de ces transistors 176 est contrôlée par des grilles arrière 178, par exemple analogues aux grilles arrière 154 précédemment décrites pour les transistors FET 152 du circuit intégré 300. Le fonctionnement des transistors FET sans jonction et à déplétion 176 est analogue au fonctionnement des transistors FET 126 précédemment décrits, excepté que la création des zones de déplétion dans les canaux est commandée en appliquant des tensions sur les grilles arrière 154.

Dans les circuits intégrés 100, 300, 400 et 500 précédemment décrits, les dispositifs FET sans jonction et à déplétion comportent chacun une portion de la couche mince de semi-conducteur cristallin 125 formant un canal 134, une source 130 et un drain 132, cette portion étant isolée du reste de la couche mince 125 par des portions diélectriques 128. Dans une variante de réalisation, il est possible de remplacer ces portions de semi-conducteur par une pluralité de nanofils formés par gravure dans la couche mince de semi-conducteur cristallin 125. Par exemple, le transistor FET 176, précédemment décrit en liaison avec le circuit intégré 500, selon cette variante de réalisation, est représenté sur la figure 8. Sur cette figure 8, le transistor 176 comporte une grille arrière 178 et plusieurs nanofils de semi-conducteur cristallin 180. Les portions de ces nanofils 180 se trouvant au-dessus de la grille arrière 178 forment des canaux 182, tandis que les portions des nanofils 180 se trouvant de chaque côté des canaux 182 forment respectivement des sources 184 et des drains 186. Les sources 184 des nanofils 180 sont reliées électriquement à un contact électrique de source 188 commun à toutes les sources 184, et les drains 186 des nanofils 180 sont reliés électriquement à un contact électrique de drain 190 commun à tous les drains 186.

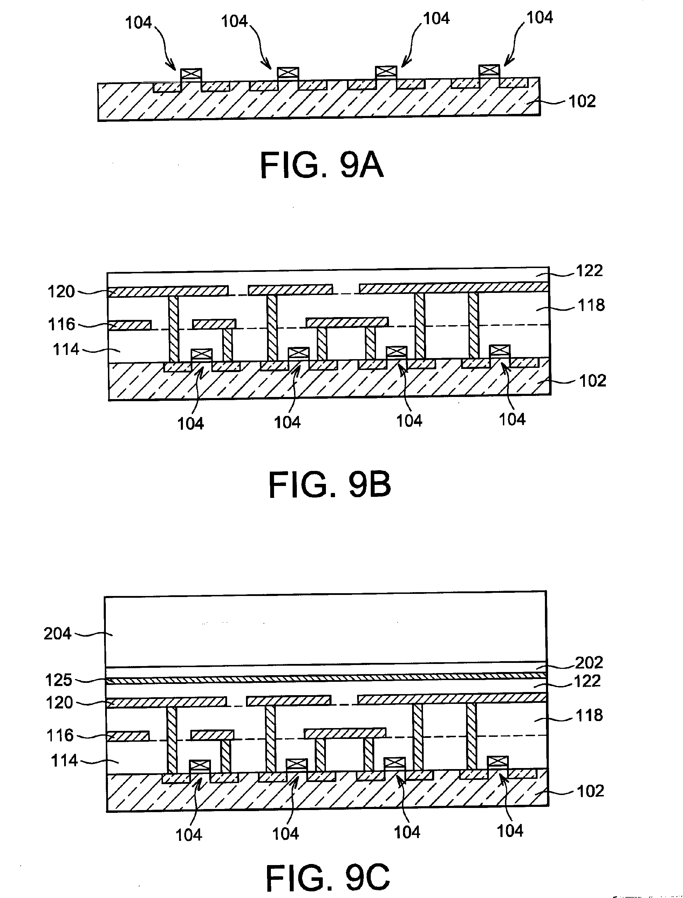

On décrit maintenant, en liaison avec les figures 9A à 9E, les étapes d'un procédé de réalisation du circuit intégré 100 selon un mode de réalisation particulier.

Comme représenté sur la figure 9A, on réalise tout d'abord dans le substrat 102 le circuit CMOS comportant les différents transistors MOS 104. Les étapes de réalisation d'un tel circuit CMOS sont connues et ne sont pas détaillées ici.

Les niveaux d'interconnexions électriques 116, 120 sont ensuite réalisés dans les couches diélectriques 114, 118 et 122 qui recouvrent le circuit CMOS précédemment réalisé dans le substrat 102. Les étapes mises en oeuvre pour réaliser ces niveaux d'interconnexions électriques et ces couches diélectriques 114, 118, 122 sont également connues et non détaillées ici.

A partir d'un autre substrat, par exemple de type SOI, comportant une couche diélectrique 202, par exemple à base de SiO₂, disposée entre la couche mince cristalline de silicium 125 et une couche massive de silicium 204, on réalise un dopage de la couche mince 125. Le type et le niveau du dopage réalisé correspond à celui que l'on souhaite obtenir dans les portions de semi-conducteur destinées à former les sources, drains et canaux des transistors FET sans jonction et à déplétion 126, et par exemple compris entre environ 10¹⁸ cm⁻³ et 10²⁰ cm⁻³. Ce dopage peut être réalisé dans toute la couche mince 125 ou bien seulement au niveau d'une partie de la couche mince 125. Par exemple, si l'on souhaite réaliser plusieurs types de transistors FET sans jonction et à déplétion dans le circuit intégré 100 (niveaux de dopage et/ou types de dopage différents), il est possible de doper différemment plusieurs portions distinctes de la couche mince de semi-conducteur cristallin 125. En variante du substrat SOI, il est possible d'utiliser un pseudosubstrat de SiGe dans lequel la couche 202 du substrat SOI est remplacée par un buffer graduel à base de SiGe.

On réalise ensuite une activation thermique des dopants implantés dans la couche mince de semi-conducteur cristallin 125. Etant donné que cette activation thermique est réalisée alors que la couche mince 125 n'est pas encore solidarisée à la structure comportant le circuit CMOS réalisé dans le substrat 102 et les niveaux d'interconnexion 116, 120, les températures atteintes lors de cette activation thermique n'ont aucun impact sur ces éléments.

Comme représenté sur la figure 9C, on réalise ensuite une solidarisation, par exemple par collage, de la couche mince de semi-conducteur cristallin 125 avec la couche diélectrique 122 recouvrant les interconnexions électriques 116 et 120. Ce transfert par collage est mis en oeuvre à faibles températures, par exemple comprises entre environ 100°C et 650°C, et de préférence inférieures à environ 450°C, afin de ne pas détériorer le circuit CMOS et les niveaux d'interconnexions électriques 116, 120.

Dans une variante, préalablement à la solidarisation de la couche mince 125 avec la couche diélectrique 122, il est possible de former sur la couche mince 125, ou sur la couche diélectrique 122, d'autres couches intermédiaires telles qu'une couche de collage, par exemple une couche d'oxyde thermique, et/ou une couche diélectrique destinée à former des diélectriques de grilles arrières. D'autres types de couches, par exemple une couche barrière et/ou une couche d'arrêt peuvent également être déposées sur la couche 125.

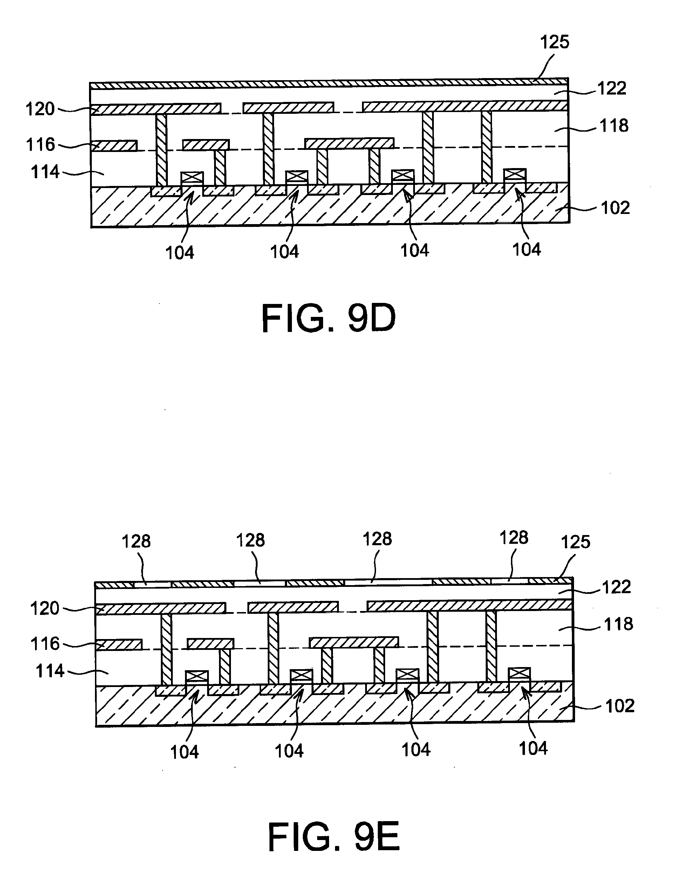

On réalise ensuite un retrait de la couche massive 204 de silicium et de la couche diélectrique 202, en mettant par exemple en oeuvre une gravure de la couche diélectrique 202 (figure 9D).

On réalise ensuite, dans la couche mince 125, une isolation des zones actives des transistors FET sans jonction et à déplétion 126 destinés à être réalisés. Pour cela, on réalise par exemple une gravure localisée de la couche mince 125 autour de ces zones actives. Il est également possible, comme cela est représenté sur la figure 9E, de réaliser des portions de matériau diélectrique 128 autour de ces zones actives, par exemple obtenues par oxydation du silicium de la couche mince 125.

Le circuit intégré 100 est ensuite achevé en réalisant les diélectriques de grilles 138 et des grilles 136 au-dessus des zones actives précédemment isolées dans la couche mince 125, formant le circuit intégré 100 représenté sur la figure 1.

Les différentes étapes mis en oeuvre après la solidarisation de la couche mince de semi-conducteur cristallin 125 avec le circuit CMOS et les niveaux d'interconnexions 116, 120 inférieurs le sont à des températures dites « froides », c'est-à-dire inférieures à environ 450°C afin de ne pas détériorer le circuit CMOS comportant les transistors 104 et les niveaux d'interconnexions 116 et 120.

Il est possible de poursuivre ce procédé en réalisant d'autres niveaux d'interconnexions électriques et/ou d'autres niveaux électroniques comportant des dispositifs FET sans jonction et à déplétion en répétant les étapes décrites en liaison avec les figures 9B à 9D, en empilant ces niveaux supplémentaires au-dessus des transistors FET 126, et cela sans détériorer ces transistors FET 126 ni les interconnexions électriques et circuits CMOS inférieurs.

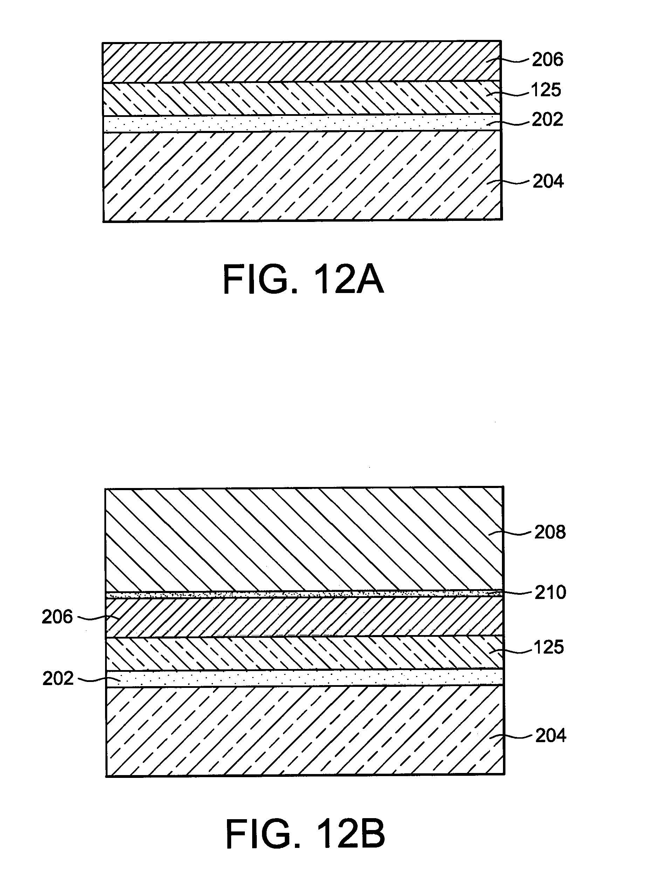

Dans une variante de réalisation, la couche de semi-conducteur cristallin 125 peut être solidarisée au substrat 102 (par l'intermédiaire notamment de la couche diélectrique 122) non pas directement à partir d'un substrat SOI, mais par l'intermédiaire d'une poignée temporaire. Ainsi, à partir de l'empilement représenté sur la figure 12A comportant la couche massive 204 de semi-conducteur, la couche diélectrique 202, la couche de semi-conducteur cristallin 125 et un empilement de matériaux de grilles 206 destinés à former par exemple les grilles 136 et les diélectriques de grille 138 des dispositifs de type FET destinés à être réalisés à partir de la couche de semi-conducteur cristallin 125, on solidarise la poignée temporaire 208 à l'empilement de matériaux de grilles 206 par l'intermédiaire d'une couche de colle 210 (figure 12B).

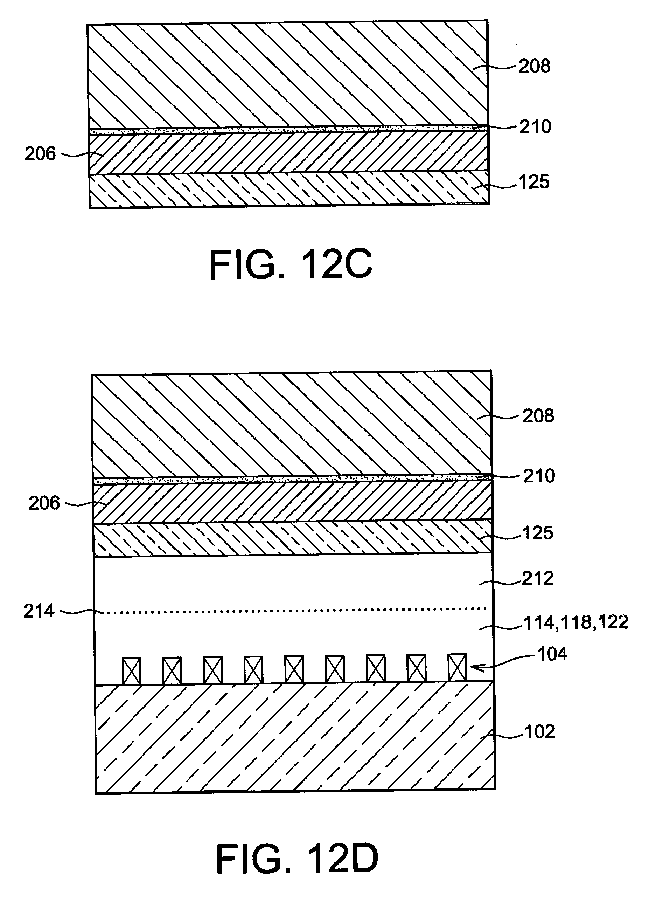

On réalise ensuite un retrait des matériaux se trouvant contre la face arrière de la couche de semi-conducteur cristallin 125, c'est-à-dire un retrait de la couche massive 204 et de la couche diélectrique 202, en mettant par exemple en oeuvre une gravure de la couche diélectrique 202 (figure 12C).

L'ensemble obtenu est ensuite solidarisé au substrat 102 sur lequel sont réalisés un ou plusieurs circuits électroniques de type MOS 104 et/ou un ou plusieurs niveaux d'interconnexions électriques (figure 12D). Cette solidarisation est par exemple réalisée par l'intermédiaire d'oxydes de collage 212 et 122 formés sur les deux structures destinées à être assemblées, solidarisés l'un à l'autre au niveau d'une interface de collage 214.

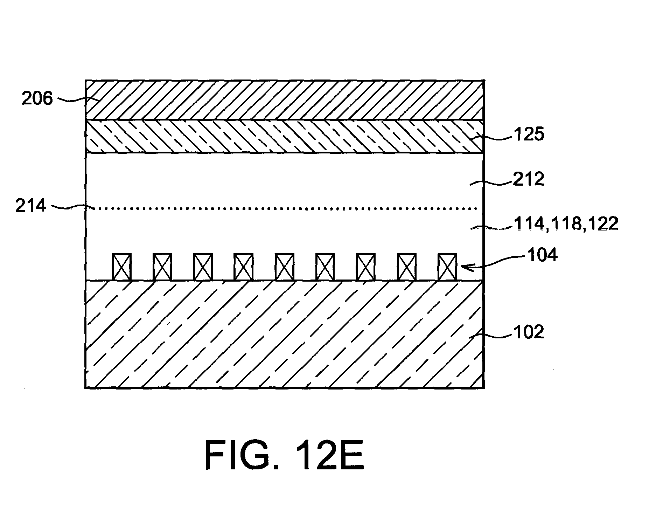

Enfin, la poignée temporaire 208 est désolidarisée de l'ensemble, la couche de colle 210 étant également supprimée (figure 12E).

Cette variante décrite en liaison avec les figures 12A à 12E permet de solidariser la face arrière de la couche de semi-conducteur cristallin 125 au substrat 102 et non sa face avant comme dans l'exemple précédemment décrit en liaison avec les figures 9A à 9E.

Le ou les dispositifs de type FET sans jonction et à déplétion sont ensuite réalisés à partir de la couche 125 et de l'empilement 206 en commençant soit par une lithographie dans la couche 125 afin de définir les zones semi-conductrices des dispositifs de type FET (en gravant ensuite la couche 125 et l'empilement 206), soit par une lithographie des empilements de grille dans les matériaux de l'empilement 206.

## Revendications

1. Procédé de réalisation d'un circuit intégré (100, 200, 300, 400, 500), comportant au moins, dans cet ordre, les étapes de :
a) réalisation d'au moins un circuit électronique de type MOS (104) et/ou d'au moins un niveau d'interconnexions électriques (116, 120) sur un substrat (102),
b) implantation uniforme de dopants dans au moins une partie d'une couche (125) de semi-conducteur cristallin,
c) activation thermique des dopants implantés dans la partie de la couche (125) de semi-conducteur cristallin,
d) solidarisation de la couche (125) de semi-conducteur cristallin au substrat (102),
e) réalisation d'au moins un dispositif (126, 140, 152, 170, 176) de type FET sans jonction et à déplétion comprenant une portion (130, 132, 134, 142, 180) de la partie de la couche (125) de semi-conducteur cristallin.

2. Procédé selon la revendication 1, comportant en outre, entre les étapes a) et d), une étape de réalisation d'au moins une couche (114, 118, 122) composée d'un matériau diélectrique recouvrant le substrat (102) et le circuit électronique de type MOS (104) et/ou le niveau d'interconnexions électriques (116, 120), la couche (125) de semi-conducteur cristallin étant solidarisée au substrat (102), à l'étape d), par l'intermédiaire de la couche (114, 118, 122) composée du matériau diélectrique.

3. Procédé selon la revendication 2, comportant en outre, lors de la réalisation de la couche (114, 118, 122) composée du matériau diélectrique, la réalisation d'une pluralité de niveaux d'interconnexions électriques (116, 120) disposés dans la couche (114, 118, 122) composée du matériau diélectrique, le circuit électronique de type MOS (104) comportant plusieurs transistors MOS reliés électriquement aux niveaux d'interconnexions électriques (116, 120) par des vias (124) formés dans la couche (114, 118, 122) composée du matériau diélectrique.

4. Procédé selon l'une des revendications précédentes, dans lequel la couche (125) de semi-conducteur cristallin est une couche superficielle d'un substrat SOI (125, 202, 204), et comportant en outre, entre les étapes d) et e), une étape de séparation de la couche (125) de semi-conducteur et d'autres éléments (202, 204) du substrat SOI.

5. Procédé selon l'une des revendications précédentes, dans lequel l'étape e) de réalisation du dispositif (126, 140, 152, 170, 176) de type FET sans jonction et à déplétion est mise en oeuvre à une température inférieure à environ 450°C.

6. Procédé selon l'une des revendications précédentes, dans lequel l'étape e) de réalisation du dispositif (126, 152, 170, 176) de type FET sans jonction et à déplétion comporte la réalisation d'une région d'isolation électrique (128) dans la couche (125) de semi-conducteur cristallin, autour de la portion (130, 132, 134, 180) de la partie de la couche (125) de semi-conducteur cristallin.

7. Procédé selon l'une des revendications précédentes, dans lequel l'étape e) de réalisation du dispositif (140, 180) de type FET sans jonction et à déplétion comporte une gravure de la couche (125) de semi-conducteur cristallin autour de la portion (142, 180) de la partie de la couche (125) de semi-conducteur cristallin, ladite portion (142, 180) formant un ou plusieurs nanofils de semi-conducteur cristallin uniformément dopé.

8. Procédé selon l'une des revendications précédentes, comportant en outre, après l'étape e) de réalisation du dispositif (152) de type FET sans jonction et à déplétion, la réalisation d'au moins une seconde couche (158, 160, 162) composée d'un matériau diélectrique recouvrant au moins le dispositif (152) de type FET sans jonction et à déplétion, et au moins un niveau d'interconnexions électriques (164, 166) disposé dans la seconde couche (158, 160, 162) composée du matériau diélectrique relié électriquement au dispositif (152) de type FET sans jonction et à déplétion par des vias (168) formés dans la seconde couche (158, 160, 162) composée du matériau diélectrique.

9. Procédé selon l'une des revendications précédentes, comportant en outre, après l'étape c), un dépôt d'au moins un diélectrique de grille (138, 144) ou la réalisation d'un empilement comportant au moins une portion de matériau apte à stocker des charges électriques disposée entre au moins deux portions de matériau diélectrique, sur la couche (125) de semi-conducteur cristallin, et la réalisation d'au moins une grille avant (136, 146) et/ou une grille arrière (154, 178) en regard du canal (134) du dispositif (126, 140, 152, 176) de type FET sans jonction et à déplétion, le diélectrique de grille (138, 144) ou ledit empilement étant disposé entre la grille avant (136, 146) et le canal (134) et/ou entre la grille arrière (154, 178) et le canal (134).

10. Procédé selon l'une des revendications précédentes, comportant en outre, entre les étapes b) et c) ou entre les étapes c) et d), un dépôt, sur la couche (125) de semi-conducteur cristallin, d'au moins une couche de collage et/ou une couche barrière et/ou une couche d'arrêt.

11. Procédé selon l'une des revendications précédentes, comportant en outre, avant la mise en oeuvre de l'étape d), la solidarisation de la couche (125) de semi-conducteur cristallin à une poignée temporaire (208), et comportant en outre, entre les étapes d) et e), la suppression de la poignée temporaire (208).

12. Procédé selon l'une des revendications précédentes, dans lequel le dispositif (126, 140, 152, 170 176) de type FET sans jonction et à déplétion est un transistor comportant un canal (134), une source (130) et un drain (132) formés par la portion (130, 132, 134) uniformément dopée de semi-conducteur cristallin, ou un transistor de mémoire de type Flash, ou un capteur chimique de type ChemFET sans jonction et à déplétion.

## Patentansprüche

1. Verfahren zur Realisierung einer integrierten Schaltung (100, 200, 300, 400, 500) mit wenigstens folgenden Schritten, in dieser Reihenfolge :
a) Realisieren wenigstens einer elektronischen Schaltung des Typs MOS (104) und/oder wenigstens einer elektrischen Zusammenschaltungsebene (116, 120) auf einem Substrat (102),
b) gleichmäßiges Implantieren von Dotierstoffen in wenigstens einen Teil einer kristallinen Halbleiterschicht (125),
c) thermisches Aktivieren der implantierten Dotierstoffe in der kristallinen Halbleiterschicht (125),
d) Verbinden bzw. Vereinigen der kristallinen Halbleiterschicht (125) mit dem Substrat (102),
e) Realisieren wenigstens einer Vorrichtung (126, 140, 152, 170, 176) in Form eines übergangslosen FET mit Verarmungsschicht, umfassend ein Teilstück (130, 132, 134, 142, 180) des Teils bzw. Abschnitts der kristallinen Halbleiterschicht (125).

2. Verfahren nach Anspruch 1, außerdem umfassend, zwischen den Schritten a) und d), einen Schritt zur Realisierung wenigstens einer Schicht (114, 118, 122), bestehend aus einem dielektrischen Material, welches das Substrat (102) und die elektronische Schaltung des Typs MOS (104) und/oder die elektrischen Zusammenschaltungsebenen (116, 120) überdeckt, wobei die kristalline Halbleiterschicht (125) mit dem Substrat (102) in Schritt d) mittels der aus dielektrischem Material bestehenden Schicht (114, 118, 122) verbunden wird.

3. Verfahren nach Anspruch 2, außerdem umfassend, während der Realisierung der aus dielektrischem Material bestehenden Schicht (114, 118, 122), die Realisierung einer Vielzahl elektrischer Zusammenschaltungsebenen (116, 120), vorgesehen in der aus dem dielektrischen Material bestehenden Schicht (114, 118, 122), wobei die elektronische Schaltung des Typs MOS (104) mehrere MOS-Transistoren umfasst, elektrisch miteinander verbunden in Höhe der elektrischen Zusammenschaltungsebene (116, 120) durch vertikale elektrische Verbindungen oder Vias (124), ausgebildet in der aus dielektrischem Material bestehenden Schicht (114, 118, 122).

4. Verfahren nach einem der vorhergehenden Ansprüche, bei dem die kristalline Halbleiterschicht (125) eine Oberflächenschicht eines SOI-Substrats (125, 202, 204) ist, und das außerdem, zwischen den Schritten d) und e), einen Trennschritt bzw. Schritt zur Trennung der Halbleiterschicht (125) und anderer Elemente bzw. von anderen Elementen (202, 204) des SOI-Substrats umfasst.

5. Verfahren nach einem der vorhergehenden Ansprüche, bei dem der Schritt e) zur Herstellung der Vorrichtung (126, 140, 152, 170, 176) des Typs übergangsloser FET mit Verarmungsschicht bei einer Temperatur unter ungefähr 450 °C durchgeführt wird.

6. Verfahren nach einem der vorhergehenden Ansprüche, bei dem der Schritt e) zur Herstellung der Vorrichtung (126, 152, 170, 176) des Typs übergangsloser FET mit Verarmungsschicht die Realisierung eines elektrischen Isolierungsbereichs (128) in der kristallinen Halbleiterschicht (125) umfasst, um das Teilstück (130, 132, 134, 180) des Teils bzw. Abschnitts der kristallinen Halbleiterschicht (125) herum.

7. Verfahren nach einem der vorhergehenden Ansprüche, bei dem der Schritt e) zur Herstellung der Vorrichtung (140, 180) des Typs übergangsloser FET mit Verarmungsschicht eine Ätzung der kristallinen Halbleiterschicht (125) um das Teilstück (142, 180) des Teils bzw. Abschnitts der kristallinen Halbleiterschicht (125) herum umfasst, wobei eine oder mehrere Nanofasern aus gleichmäßig dotiertem kristallinem Halbleiter das genannte Teilstück (142, 180) bilden.

8. Verfahren nach einem der vorhergehenden Ansprüche, außerdem, nach dem Schritt e) zur Realisierung der Vorrichtung (152) des Typs übergangsloser FET mit Verarmungsschicht, die Realisierung wenigstens einer zweiten Schicht (158, 160, 162) umfassend, bestehend aus einem dielektrischen Material, überdeckend: wenigstens die Vorrichtung (152) des Typs übergangsloser FET mit Verarmungsschicht, und wenigstens eine elektrische Zusammenschaltungsebene (164, 166), angeordnet in der zweiten aus dielektrischem Material bestehenden Schicht (158, 160, 162), elektrisch verbunden mit der Vorrichtung (152) des Typs übergangsloser FET mit Verarmungsschicht durch Vias (168), ausgebildet in der zweiten aus dielektrischem Material bestehenden Schicht (158, 160, 162).

9. Verfahren nach einem der vorhergehenden Ansprüche, außerdem umfassend, nach dem Schritt c) : eine Abscheidung wenigstens eines Gate-Dielektrikums (138, 144) oder die Realisierung eines Stapels, umfassend wenigstens ein Stück aus einem zur Speicherung elektrischer Ladungen fähigen Material, angeordnet zwischen wenigstens zwei Stücken aus dielektrischem Material, auf der kristallinen Halbleiterschicht (125), und die Realisierung wenigstens eines vorderen Gates (136, 146) und/oder eines hinteren Gates (154, 178) gegenüber des Kanals (134) der Vorrichtung (126, 140, 152, 176) des Typs übergangsloser FET mit Verarmungsschicht, wobei das Gate-Dielektrikum (138, 144) oder der genannte Stapel zwischen dem vorderen Gate (136, 146) und dem Kanal (134) und/oder dem hinteren Gate (154, 178) und dem Kanal angeordnet ist.

10. Verfahren nach einem der vorhergehenden Ansprüche, außerdem umfassend, zwischen den Schritten b) und c) oder zwischen den Schritten c) und d) : eine Abscheidung, auf der kristallinen Halbleiterschicht (125), von wenigstens einer Schließschicht (couche de collage) und/oder einer Sperrschicht und/oder einer Stoppschicht.

11. Verfahren nach einem der vorhergehenden Ansprüche, das außerdem, vor der Durchführung von Schritt d), die Befestigung der kristallinen Halbleiterschicht (125) an einem temporären Griff (208) umfasst, und zudem, zwischen den Schritten d) und e), die Beseitigung des temporären Griffs (208) umfasst.

12. Verfahren nach einem der vorhergehenden Ansprüche, bei dem die Vorrichtung (126, 140, 152, 170, 176) des Typs übergangsloser FET mit Verarmungsschicht ein Transistor ist, umfassend einen Kanal (134), eine Source (130) und einen Drain (132), gebildet durch das gleichmäßig dotierte kristalline Halbleiterteilstück (130, 132, 134), oder ein Speichertransistor des Flash-Typs ist, oder ein chemischer Sensor des Typs übergangsloser ChemFET mit Verarmungsschicht ist.

## Claims

1. Method for producing an integrated circuit (100, 200, 300, 400, 500), including at least, in this order, the following steps:
a) production of at least one MOS electronic circuit (104) and/or at least one level of electrical interconnections (116, 120) on a substrate (102),
b) uniform implantation of dopants in at least a portion of a layer (125) of crystalline semiconductor,
c) thermal activation of the dopants implanted in the portion of the layer (125) of crystalline semiconductor,
d) interlocking of the layer (125) of crystalline semiconductor to the substrate (102),
e) production of at least one junctionless depletion-mode FET device (126, 140, 152, 170, 176) including a part (130, 132, 134, 142, 180) of the portion of the layer (125) of crystalline semiconductor.

2. Method according to claim 1, also including, between steps a) and d), a step of production of at least one layer (114, 118, 122) comprising a dielectric material covering the substrate (102) and the MOS electronic circuit (104) and/or the level of electrical interconnections (116, 120), where the layer (125) of crystalline semiconductor is interlocked to the substrate (102), in step d), with the layer (114, 118, 122) comprising the dielectric material in between.

3. Method according to claim 2, also including, during production of the layer (114, 118, 122) comprising the dielectric material, the production of multiple levels of electrical interconnections (116, 120) arranged in the layer (114, 118, 122) comprising the dielectric material, where the MOS electronic circuit (104) includes several MOS transistors electrically connected to the levels of electrical interconnections (116, 120) by vias (124) made in the layer (114, 118, 122) comprising the dielectric material.

4. Method according to one of the previous claims, in which the layer (125) of crystalline semiconductor is a surface layer of an SOI substrate (125, 202, 204), also including, between steps d) and e), a step of separation of the layer (125) of semiconductor and of other elements (202, 204) of the SOI substrate.

5. Method according to one of the previous claims, in which step e) of production of the junctionless and depletion-mode FET device (126, 140, 152, 170, 176) is implemented at a temperature of less than approximately 450°C.

6. Method according to one of the previous claims, in which step e) of production of the junctionless depletion-mode FET device (126, 152, 170, 176) includes the production of an area of electrical insulation (128) in the layer (125) of crystalline semiconductor, around the part (130, 132, 134, 180) of the portion of the layer (125) of crystalline semiconductor.

7. Method according to one of the previous claims, in which step e) of production of the junctionless depletion-mode FET device (140, 180) includes etching of the layer (125) of crystalline semiconductor around the part (142, 180) of the portion of the layer (125) of crystalline semiconductor, where said part (142, 180) forms one or more nanowires of uniformly doped crystalline semiconductor.

8. Method according to one of the previous claims, also including, after step e) of production of the junctionless depletion-mode FET device (152), production of at least one second layer (158, 160, 162) comprising a dielectric material covering at least the junctionless depletion-mode FET device (152), and at least one level of electrical interconnections (164, 166) positioned in the second layer (158, 160, 162) comprising the dielectric material connected electrically to the junctionless depletion-mode FET device (152) by vias (168) formed in the second layer (158, 160, 162) comprising the dielectric material.

9. Method according to one of the previous claims, also including, after step c), deposition of at least one gate dielectric (138, 144) or the production of a stack including at least one part of material able to store electrical charges positioned between at least two parts of dielectric material, on the layer (125) of crystalline semiconductor, and production of at least one front gate (136, 146) and/or one back gate (154, 178) opposite the channel (134) of the junctionless depletion-mode FET device (126, 140, 152, 176), where the gate dielectric (138, 144) or said stack is positioned between the front gate (136, 146) and the channel (134) and/or between the back gate (154, 178) and the channel (134).

10. Method according to one of the previous claims, also including, between steps b) and c) or between steps c) and d), deposition, on the layer (125) of crystalline semiconductor, of at least one bonding layer and/or one barrier layer and/or one stop layer.

11. Method according to one of the previous claims, also including, before implementation of step d), an interlocking of the layer (125) of crystalline semiconductor to a temporary handle (208), and also including, between steps d) and e), elimination of the temporary handle (208).

12. Method according to one of the previous claims, in which the junctionless depletion-mode FET device (126, 140, 152, 170, 176) is a transistor including a channel (134), a source (130) and a drain (132) formed by the uniformly doped part (130, 132, 134) of crystalline semiconductor, or a flash memory transistor, or a chemical sensor of the junctionless depletion-mode ChemFET type.
